# EUROPÄISCHE PATENTANMELDUNG

(11) **EP 3 563 952 A1**
(43) Veröffentlichungstag der Anmeldung: **06.11.2019**
(21) Anmeldenummer: 18170607.8
(22) Anmeldetag: 03.05.2018
(51) Int. Cl.: B23B 27/14, B23B 27/16, C23C 28/04, C23C 28/00, C23C 30/00, C23C 14/06

(54) **SCHNEIDVORRICHTUNG**

(71) Anmelder: Ceratizit Austria Gesellschaft m.b.H., 6600 Reutte (AT)
(72) Erfinder: HINTZE, Wolfgang, 21077 Hamburg (DE); BRÜGMANN, Felix, 21073 Hamburg (DE); SCHLEINKOFER, Uwe, 6600 Reutte (AT)
(74) Vertreter: Torggler & Hofinger Patentanwälte

(57) **Zusammenfassung**

Schneidvorrichtung mit:
- einem Substrat (1) aus einem hochharten Material aus ultraharten Körnern, bestehend aus kubischem Bornitrid oder aus Diamant, und einem Binder, wobei der Gehalt der ultraharten Körner größer als 50 Vol-% des Verbundkörpers ist, bevorzugt größer als 90 Vol-%
- wobei das Substrat (1) zumindest eine zwischen zwei Funktionsflächen (2, 3) definierte Schneide (4) aufweist und wobei zumindest eine der zwei Funktionsflächen (2, 3) zumindest teilweise durch eine hochharte Verschleißschutzschicht (5) aus kubischem Bornitrid oder polykristallinem Diamant bedeckt ist
wobei sich die hochharte Verschleißschutzschicht (5) über die zumindest eine Schneide (4) zur anderen der zwei Funktionsflächen (2, 3) erstreckt und diese zumindest teilweise, bevorzugt vollständig bedeckt.

## Beschreibung

Die vorliegende Erfindung betrifft eine Schneidvorrichtung mit den Merkmalen des Oberbegriffs des Anspruchs 1 und eine Verwendung einer solchen Schneidvorrichtung.

Unter einem Hartmetall wird in der vorliegenden Offenbarung ein pulvermetallurgisch hergestellter Teilchenverbundwerkstoff, welcher überwiegend aus einer Hartstoffphase (z. B. Wolframkarbid, kurz "WC") besteht und weiters ein Bindemetall (z. B. Kobalt, kurz "Co", auch als "Binder" bezeichnet) aufweist, verstanden. Das Bindemetall kann rein oder in Form einer Legierung vorliegen.

Allgemein bekannte Schneidvorrichtungen zur Bearbeitung stark abrasiver Werkstoffe, wie z. B. CMC (Ceramic Matrix Composites), MMC (Metal Matrix Composites), CFK (carbonfaserverstärkte Kunststoffe), Holzwerkstoffe, MDF (mitteldichte Faserplatten), Gips, Faserverbundwerkstoffe, bestehen typischerweise aus Hartmetall mit oder ohne Beschichtung, Diamant oder kubischem Bornitrid (c-BN).

Die Schneidstoffe Hartmetall und Diamant unterliegen bei der Bearbeitung abrasiver Werkstoffe tendenziell einem hohen Verschleiß, der allgemein zu einem in Richtung der als Freifläche fungierenden Funktionsfläche ausgebildeten Schneidenverschleiß sowie zu einer Verrundung der Schneide führt, woraus hohe Bearbeitungskräfte und geringe Schnittqualitäten resultieren. Eine konventionelle CVD-Schicht neigt zum Bröckeln an der Schneide und ist für eine schwellende thermomechanische Belastung oft ungeeignet.

Die Diamantbeschichtung von Hartmetallwerkzeugen bewirkt naturgemäß einen höheren Verschleißschutz, wodurch deren Standzeit erhöht wird. Zugleich bewirkt im technischen Einsatz die für die Schichthaftung notwendige Schichtdicke einen um etwa die Schichtdicke größeren Schneidkantenradius. Dieses kann die Bearbeitungsqualität z. B. in Form von Gratbildung oder Delamination vermindern.

Die Wärmeleitfähigkeiten von Hartmetall und Diamant unterscheiden sich deutlich, weshalb es an der Grenze zwischen Substrat und Schicht zu einem Wärmestau und somit einer höheren thermischen Belastung kommen kann. Dazu kommen Spannungen im Interface infolge unterschiedlicher thermischer Ausdehnungskoeffizienten. Die Folge hieraus ist, dass der Verschleiß diamantbeschichteter Hartmetallwerkzeuge typischerweise durch ein partielles Ablösen der Schicht vom Substrat aufgrund der thermomechanischen Belastung anstelle eines abrasiven Abtrags der Schicht erfolgt. Somit wird das Potenzial der Schicht nicht ausgenutzt. Eine Maßnahme zur Vermeidung des Abplatzens ist die Wahl hoher Schichtdicken, wodurch diese eine Eigensteifigkeit erlangen. Dies ist jedoch mit dem erheblichen Nachteil einer entsprechend angehobenen Schneidenverrundung verbunden. Außerdem bedingen dickere Schichten längere Beschichtungszeiten und damit erheblich höhere Beschichtungskosten bei reduzierter Zuverlässigkeit im technischen Einsatz.

Für die Bearbeitung von Stahlwerkstoffen sind Diamantschneidstoffe aufgrund der Affinität von Kohlenstoff und Eisen ungeeignet. Der Schneidstoff c-BN bietet aufgrund der hohen Härte eine Alternative, Ebenfalls werden Beschichtungen z. B. aus c-BN, TiCN (Titancarbonitrid) oder TiAIN (Titanaluminiumnitrid) eingesetzt, die für eine höhere Verschleißfestigkeit sorgen sollen, wobei jedoch TiCN und TiAIN hinsichtlich der Warmhärte Einschränkungen aufweisen.

Eine Schneidvorrichtung mit den Merkmalen des Oberbegriffs des Anspruchs 1 geht aus JPH04-261703 hervor. Problematisch an diesem Stand der Technik ist, dass die dort gezeigte Schneidvorrichtung eine unzureichende Standzeit aufweist, hervorgerufen durch physikalische und chemische Verschleißmechanismen.

Aufgabe der Erfindung ist eine Erhöhung der Standzeit einer gattungsgemäßen Schneidvorrichtung.

Diese Aufgabe wird durch eine Schneidvorrichtung mit den Merkmalen des Anspruchs 1 und eine Verwendung mit den Merkmalen des Anspruchs 14 gelöst. Vorteilhafte Ausführungsformen der Erfindung sind in den abhängigen Ansprüchen definiert.

Die Erfindung sieht vor, dass sich die hochharte Verschleißschutzschicht aus kubischem Bornitrid oder polykristallinem Diamant (PKD) von der einen Funktionsfläche über die zumindest eine Schneide zur anderen der zwei Funktionsflächen erstreckt und diese zumindest teilweise, bevorzugt vollständig bedeckt. Beide Funktionsflächen können vollständig von der hochharten Verschleißschutzschicht bedeckt sein.

Durch die Erfindung wird gewährleistet, dass die verschleißmindernde Wirkung in Bezug auf alle Wirkflächen (Schneiden und Funktionsflächen), welche mit dem ablaufenden Span und dem Werkstück in Verbindung kommen, erzielt wird. Moderne Beschichtungsverfahren führen dazu, dass heutzutage auch im Beschichtungsprozess relativ scharfe Schneidkanten erzielt werden können.

Die Erfindung realisiert extrem verschleißbeständige und zugleich im Vergleich zum Stand der Technik zähere Schneiden. Weiter können diese zur Reduktion von Kräften, Temperaturen und Gratbildung mit geringerer Schneidenverrundung ausgeführt werden. Durch die möglichen geringeren Schichtdicken werden die Beschichtungszeiten und -kosten erheblich reduziert und wird die Zuverlässigkeit der Schneide im technischen Einsatz erhöht. Die verbesserte Wärmeabfuhr und Schichthaftung gestatten es, schwierig bearbeitbare Werkstoffe mit erhöhten Schnittparametern, insbesondere Schnittgeschwindigkeiten und Vorschüben, schädigungsfrei und bei ausreichender Standzeit zu bearbeiten.

Eine erfindungsgemäße Schneidvorrichtung wird bevorzugt für die Bearbeitung von Faserverbundwerkstoffen oder Leichtmetallen oder hochharten Werkstoffen wie z. B. Hartmetall und Keramik oder für die Bearbeitung von Verbundwerkstoffen aus den vorgenannten Materialien verwendet.

Bevorzugt ist die hochharte Verschleißschutzschicht ohne Zwischenschicht, unmittelbar am Substrat angeordnet.

Die Dicke der hochharten Verschleißschutzschicht liegt bevorzugt in einem Bereich von 1 bis 20 Mikrometer.

In einem Ausführungsbeispiel der Erfindung ist das Substrat der Schneidvorrichtung - bevorzugt stoffschlüssig und lotmittelfrei - mit einem Trägerkörper verbunden. PKD-Werkzeuge werden typischerweise durch das Einlöten von PKD-Blanks in einen Grundkörper aus Hartmetall hergestellt. Eine Diamantbeschichtung eines solchen Werkzeuges kann durch die hohen Beschichtungstemperaturen zum Ablösen der Blanks an der Lötstelle führen, da der Schmelzpunkt des Lotes überschritten wird.

Es kann vorgesehen sein, dass das Substrat - vorzugsweise stoffschlüssig und lotmittelfrei - mit einer weiteren Lage (vorzugsweise aus Hartmetall) verbunden ist, wobei die weitere Lage mit einem Trägerkörper stoffschlüssig und lotmittelfrei, kraft-, reib-, und/oder formschlüssig verbunden ist. Dies kann z. B. für Wechselköpfe vorteilhaft sei.

Alternativ kann vorgesehen sein, dass Substrat kraft-, reib-, und/oder formschlüssig direkt mit einem Trägerkörper verbunden ist. Dies kann z. B. für Voll-c-BN-Wendeschneidplatten vorteilhaft sein.

Der Trägerkörper kann dabei als austauschbarer Schneideinsatz, vorzugsweise als Wendeschneidplatte, oder als Grundkörper eines rotierenden oder stehenden Werkzeugs mit einem Einspannabschnitt für das Einspannen an einer Aufnahme in einer Werkzeugmaschine ausgebildet sein.

Der Grundkörper der Schneidvorrichtung kann z. B. aus Hartmetall und die hochharte Verschleißschutzschicht aus Bornitrid oder aus polykristallinem Diamant bestehen.

Die Oberflächenrauheit einer Schicht aus polykristallinem Diamant sinkt mit geringerer Korngröße, weshalb feine Korngrößen oder ein aus groben und feinen Körnern bestehender multimodaler Aufbau bevorzugt werden.

Bei einem Ausführungsbeispiel besteht das Substrat, auf welchem die hochharte Verschleißschutzschicht aus Diamant (Schichtdicke zwischen 1 bis 20 Mikrometer) angeordnet ist, aus PKD mit einem Co-Binderanteil kleiner als 8 % und einer Korngröße kleiner als 2 Mikrometer, vorzugsweise kleiner als 1 Mikrometer. Diese Ausführung verbindet eine hohe Schlagzähigkeit mit einer über die Schichtdicke wählbaren Verschleißbeständigkeit.

Bei einem Ausführungsbeispiel besteht das Substrat, auf welchem die hochharte Verschleißschutzschicht (Schichtdicke zwischen 1 bis 20 Mikrometer) angeordnet ist, aus PKD mit einem Co-Binderanteil kleiner als 8 % und einer Korngröße größer als 2 Mikrometer, vorzugsweise größer als 10 Mikrometer oder einem aus groben und feinen Körnern bestehenden multimodalen Aufbau. Diese Ausführung erlaubt die über die Schichtdicke entsprechend der zulässigen Schneidenverrundung wählbare höchste Verschleißbeständigkeit für Schlichtbearbeitungen bei niedriger Gratbildung im Falle duktiler Werkstoffe, minimalen Ausbrüchen im Fall spröder Werkstoffe und minimalen Faserüberständen oder Delaminationen im Falle langfaserverstärkter Werkstoffe.

Bei einem weiteren Ausführungsbeispiel besteht das Substrat aus PKD und die Verschleißschutzschicht aus c-BN. Diese Ausführung erlaubt eine chemische Beständigkeit bis zu sehr hohen Kontaktzonentemperaturen, die in der Größenordnung oder oberhalb der Beschichtungstemperatur liegen, bei zugleich optimaler Wärmeabfuhr.

Bei einem Ausführungsbeispiel besteht das Substrat, auf welchem die hochharte Verschleißschutzschicht (Schichtdicke zwischen 1 bis 20 Mikrometer) angeordnet ist, aus kubischem Bornitrid mit einem Binderanteil bestehend aus Metallboriden oder Nitriden oder Carbiden, vorzugsweise der Elemente W und Co, mit einem Anteil kleiner als 20 %, vorzugsweise kleiner als 12 % und einer Korngröße größer als 4 Mikrometer, vorzugsweise größer als 8 Mikrometer. Diese Ausführung erlaubt höchste Verschleißbeständigkeit infolge vorteilhafter Wärmeabfuhr bei extremer thermomechanischer Belastung sowie Oxidations- und Diffusionsneigung, die beispielsweise bei harten Stahl- und Gusswerkstoffen und/oder im kontinuierlichen Schnitt auftritt. Dabei ist die Verschleißbeständigkeit über die Schichtdicke und die entsprechende Beschichtungsdauer unter Wirtschaftlichkeitsaspekten sowie gemäß dem Erfordernis an die Schneidenschärfe wählbar.

Bei einem Ausführungsbeispiel besteht das Substrat, auf welchem die hochharte Verschleißschutzschicht (Schichtdicke zwischen 1 bis 20 Mikrometer) angeordnet ist, aus kubischem Bornitrid mit einem Binderanteil bestehend aus Metallboriden oder Nitriden oder Carbiden, vorzugsweise der Elemente W und Co, mit einem Anteil kleiner als 20 %, vorzugsweise kleiner als 12 % und eine Korngröße kleiner als 4 Mikrometer, vorzugsweise kleiner als 2 Mikrometer. Diese Ausführung erlaubt eine sehr hohe Verschleißbeständigkeit infolge vorteilhafter Wärmeabfuhr bei extremer stoßartiger, thermomechanischer Belastung sowie Oxidations- und Diffusionsneigung, die beispielsweise bei harten Stahl- und Gusswerkstoffen und/oder im kontinuierlichen Schnitt auftritt. Dabei ist die Verschleißbeständigkeit über die Schichtdicke und die entsprechende Beschichtungsdauer unter Wirtschaftlichkeitsaspekten sowie gemäß dem Erfordernis an die Schneidenschärfe wählbar.

Bei einem Ausführungsbeispiel besteht das Substrat, auf welchem die hochharte Verschleißschutzschicht (Schichtdicke zwischen 1 bis 20 Mikrometer) angeordnet ist, aus kubischem Bornitrid mit einem Binderanteil von 30 bis 55 % bestehend aus einer keramischen Phase, vorzugsweise TiC (Titankarbid), und einer Korngröße kleiner als 4 Mikrometer, vorzugsweise kleiner als 2 Mikrometer. Diese Ausführung erlaubt die über die Schichtdicke entsprechend der zulässigen Schneidenverrundung wählbare höchste Verschleißbeständigkeit für die Schlichtbearbeitung gehärteter Stähle.

Es kann vorgesehen sein, dass die Dicke der hochharten Verschleißschutzschicht mindestens halb so groß, vorzugsweise mindestens zweimal so groß wie die Korngröße des kubischen Bornitrids oder polykristallinen Diamants ist.

Von den zwei Funktionsflächen, welche gemeinsam die zumindest eine Schneide definieren und welche erfindungsgemäß über die zumindest eine Schneide hinweg zumindest teilweise mit der hochharten Verschleißschutzschicht bedeckt sind, fungiert die eine Funktionsfläche als Spanfläche und die andere Funktionsfläche als Freifläche. Die Spanfläche ist jene Fläche, auf welcher der Span abläuft, die Freifläche ist jene Fläche, welche der Schnittfläche zugekehrt ist.

Selbstverständlich kann die Schneidvorrichtung eine komplexere Geometrie mit mehr als nur einer Schneide aufweisen, beispielsweise mit zwei Schneiden, welche sich bevorzugt in einer ggf. abgerundeten Schneidenecke treffen, und mit drei Funktionsflächen. In diesem Fall wird die eine Schneide von einer als Spanfläche fungierenden ersten Funktionsfläche und einer als Freifläche fungierenden zweiten Funktionsfläche definiert. Die andere Schneide wird von der ersten Funktionsfläche und einer als Freifläche fungierenden dritten Funktionsfläche definiert. Beide Schneiden, die Spanfläche und die Freiflächen sind in diesem Fall zumindest teilweise, bevorzugt vollständig mit der hochharten Verschleißschutzschicht bedeckt.

Ausführungsbeispiele der Erfindung werden anhand der Figuren diskutiert. Es zeigen:
- Fig. 1a-1c: ein erstes Ausführungsbeispiel der Erfindung in Form einer Wendeschneidplatte
- Fig. 2a, 2b: ein zweites Ausführungsbeispiel der Erfindung in Form eines Mehrstufenbohrers
- Fig. 3: ein drittes Ausführungsbeispiel der Erfindung in Form eines Bohrers

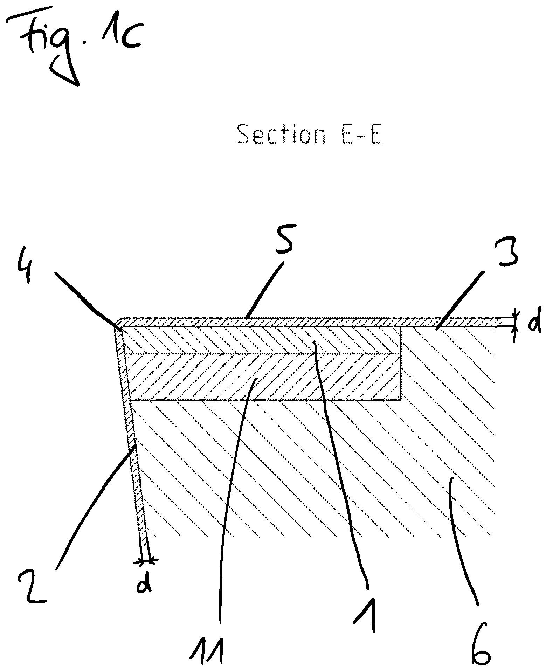

Das Vorhandensein der hochharten Verschleißschutzschicht 5 wird mit Ausnahme der Fig. 1c, da diese eine Schnittdarstellung zeigt, in den restlichen Figuren durch eine Punktierung der entsprechenden Flächen dargestellt.

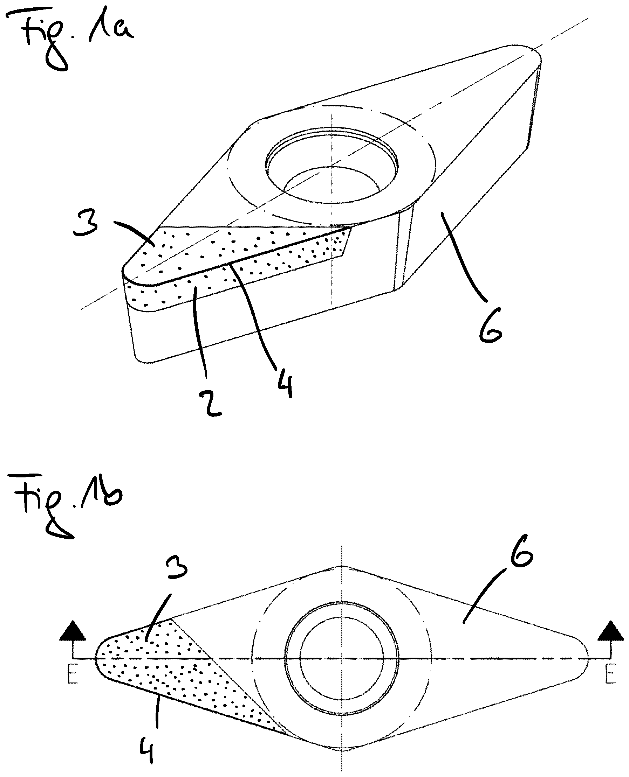

Fig. 1a zeigt eine isometrische Darstellung eines ersten Ausführungsbeispiels einer erfindungsgemäßen Schneidvorrichtung in Form eines auswechselbaren Schneideinsatzes, insbesondere einer Wendeschneidplatte. Ein solcher Schneideinsatz kann zum Drehen, Bohren oder Fräsen verwendet werden, wobei in den Fig. 1a bis 1c beispielhaft ein auswechselbarer Schneideinsatz für eine Drehbearbeitung gezeigt ist. Bei Verschleiß der verwendeten Schneide 4 kann der Schneideinsatz ausgewechselt werden. Im Fall einer Wendeschneidplatte kann diese verdreht und bei Bedarf gewendet werden, bis alle vorhandenen Schneiden 4 aufgebraucht sind.

In Fig. 1 ist nur in Bezug auf einer der vorhandenen Schneiden 4 die erfindungsgemäße Anbringung einer hochharten Verschleißschutzschicht 5 gezeigt, diese kann aber in Bezug auf zumindest eine weitere oder in Bezug auf alle Schneiden 4 vorgesehen sein.

Das Substrat 1 aus einem hochharten Material aus ultraharten Körnern, bestehend aus kubischen Bornitrid oder aus Diamant, und einem Binder ist (vgl. Fig. 1c) stoffschlüssig und lotmittelfrei mit einem Trägerkörper 6 verbunden. Fig. 1b zeigt eine Draufsicht. Die erste Funktionsfläche 2 und die zweite Funktionsfläche 3 schließen miteinander eine Schneide 4 ein. Eine erste Funktionsfläche 2 fungiert als Freifläche. Eine zweite Funktionsfläche 3 fungiert als Spanfläche.

Wie aus der Schnittdarstellung der Fig. 1c (Schnittebene E - E in Fig. 1b, in Fig. 1c nur teilweise dargestellt) hervor geht, ist eine hochharte Verschleißschutzschicht 5 vorgesehen, die sich ausgehend von der ersten Funktionsfläche 2 über die Schneide 4 hinweg zur zweiten Funktionsfläche 3 erstreckt und diese bedeckt. Die hochharte Verschleißschutzschicht 5 besteht aus kubischem Bornitrid oder polykristallinem Diamant und weist bevorzugt eine Dicke d in einem Bereich von 1 bis 20 Mikrometer auf. Der Trägerkörper 6 besteht aus einem Hartmetall. Das Substrat 1 ist in eine Ausnehmung am Trägerkörper 6 eingesetzt und mit diesem verbunden. Bei der dargestellten Realisierung ist das Substrat über eine weitere Lage 11 aus Hartmetall mit dem ebenfalls aus Hartmetall gebildeten Trägerkörper 6 verbunden. Gemäß einer alternativen Ausgestaltung, kann das Substrat 1 aus dem hochharten Material aber auch direkt, ohne eine solche als Zwischenlage fungierende weitere Lage 11 mit dem Trägerkörper 6 verbunden sein. Die Verbindung von weiterer Lage 11 und Trägerkörper 6 kann auch reib-/ kraft- und formschlüssig erfolgen.

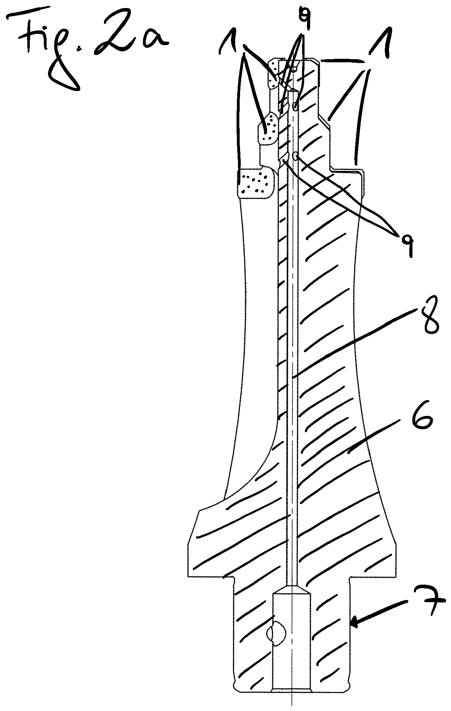

Fig. 2a zeigt eine teilweise Schnittdarstellung eines Mehrstufenbohrers mit einer Vielzahl von Schneidvorrichtungen. Die Schneidvorrichtungen sind in ungleichmäßigen Winkelabständen über den Umfang eines gemeinsamen Trägerkörpers 6 verteilt.

Mit derartigen Mehrstufenbohrern können Bohrungen mit komplexer Geometrie in einem Werkstück aus insbesondere einem langspanenden Material ausgebildet werden.

Jede der Schneidvorrichtungen weist ein Substrat 1 aus einem hochharten Material aus ultraharten Körnern, bestehend aus kubischen Bornitrid oder aus Diamant, und einem Binder auf. Über einen zentralen Kanal 8 und von diesem abzweigenden Zweigkanälen 9 kann ein Medium (flüssig/gasförmig) zur Kühlung und/oder Schmierung und/oder zum Abtransport von Spänen zu den Schneidvorrichtungen transportiert werden. Eine erste Funktionsfläche 2 fungiert als Spanfläche. Zweite Funktionsflächen 3 fungieren als Freiflächen. Wie erkennbar ist, sind pro Substrat 1 zwei Schneiden 4 vorgesehen, von denen die eine Schneide 4 zur Ausbildung von parallel zu einer Bohrungsachse verlaufenden Bohrungswänden vorgesehen ist und die andere Schneide 4 zur Ausbildung von schräg oder quer zur Bohrungsachse verlaufenden Bohrungswänden vorgesehen ist. Die beiden Schneiden 4 eines Substrats 1 treffen sich in einer ggf. abgerundeten Schneidenecke.

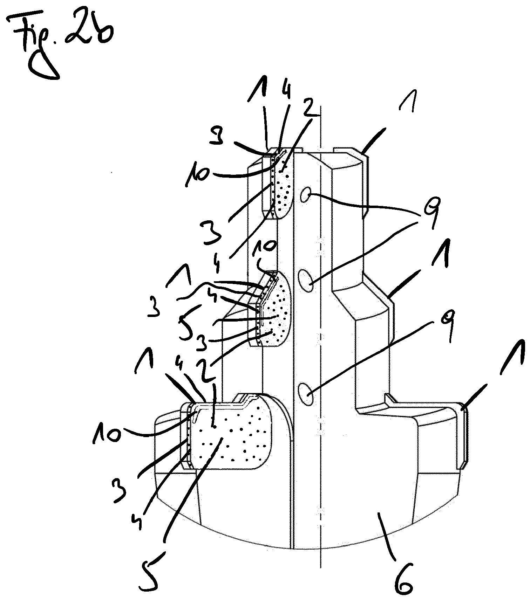

In der dazu gehörigen Fig. 2b ist erkennbar, dass sich die hochharte Verschleißschicht 5 bei jedem Substrat 1 über beide Funktionsflächen 2, 3 und beide Schneiden 4 erstreckt. Jede Schneidvorrichtung ist mit optionalen Spanleitstufen 10 versehen, welche in Form von Vertiefungen in den ersten Funktionsflächen 2 ausgebildet sind.

Der Trägerkörper 6 der Schneidvorrichtung weist einen Einspannabschnitt 7 für das Einspannen an einer Werkzeugmaschine auf und kann über diesen zum Bohren in eine Rotationsbewegung versetzt werden.

Weitere Details zur konstruktiven Ausbildung eines solchen Mehrstufenbohrers können der WO 2017/059466 A1 entnommen werden.

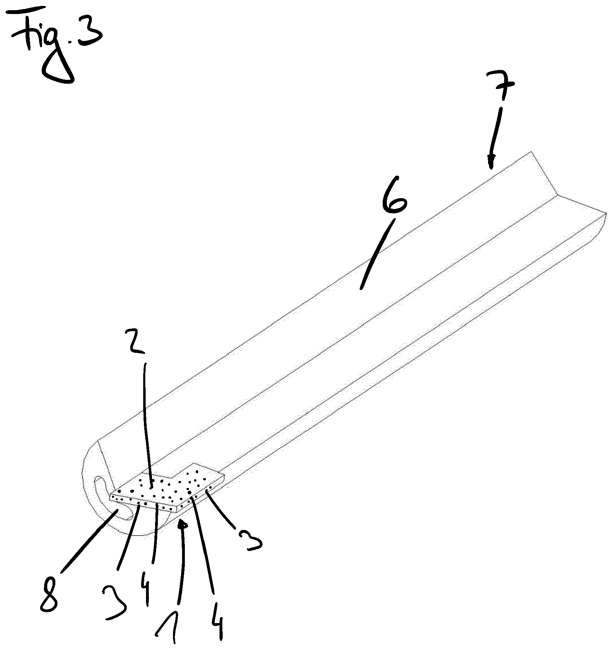

Auch die in Fig. 3 gezeigte Schneidvorrichtung mit Innenkühlung weist eine hochharte Verschleißschicht 5 auf, die sich über die Funktionsflächen 2, 3 und die Schneiden 4 erstreckt.

Das Substrat 1 ist in eine Ausnehmung an einem länglich ausgebildeten Trägerkörper 6 eingesetzt. Der gezeigte Bohrer eignet sich aufgrund der Länge des Trägerkörpers 6 insbesondere zum Tieflochbohren.

Eine erste Funktionsfläche 2 fungiert als Spanfläche. Zweite Funktionsflächen 3 fungieren als Freiflächen. Die beiden Schneiden 4 treffen sich in einer Schneidenecke.

Über einen zentralen Kanal 8 kann stirnseitig ein Medium zur Kühlung und/oder Schmierung und/oder zum Abtransport von Spänen zugeführt werden. Des Weiteren dient eine über den zentralen Kanal 8 bevorzugt mit hohem Druck zugeführte Flüssigkeit zur mechanischen Stabilisierung des Trägerkörpers 6 bei der Ausführung der Rotationsbewegung während der spanabtragenden Bearbeitung eines Werkstückes.

Das von der stirnseitigen Öffnung des Kanals 8 abgewandte Ende des Trägerkörpers 6 fungiert als Einspannabschnitt 7 für das Einspannen an einer Werkzeugmaschine.

### Bezugszeichenliste:

- 1: Substrat der Schneidvorrichtung
- 2: Funktionsfläche
- 3: Funktionsfläche
- 4: Schneide
- 5: hochharte Verschleißschutzschicht
- 6: Trägerkörper der Schneidvorrichtung
- 7: Einspannabschnitt
- 8: Kanal
- 9: Zweigkanäle
- 10: Spanleitstufe
- 11: weitere Lage

- d: Dicke der hochharten Verschleißschutzschicht

## Patentansprüche

1. Schneidvorrichtung mit:
- einem Substrat (1) aus einem hochharten Material aus ultraharten Körnern, bestehend aus kubischem Bornitrid oder aus Diamant, und einem Binder, wobei der Gehalt der ultraharten Körner größer als 50 Vol-% des Verbundkörpers ist, bevorzugt größer als 90 Vol-%
- wobei das Substrat (1) zumindest eine zwischen zwei Funktionsflächen (2, 3) definierte Schneide (4) aufweist und wobei zumindest eine der zwei Funktionsflächen (2, 3) zumindest teilweise durch eine hochharte Verschleißschutzschicht (5) aus kubischem Bornitrid oder polykristallinem Diamant bedeckt ist
**dadurch gekennzeichnet, dass** sich die hochharte Verschleißschutzschicht (5) über die zumindest eine Schneide (4) zur anderen der zwei Funktionsflächen (2, 3) erstreckt und diese zumindest teilweise, bevorzugt vollständig bedeckt.

2. Schneidvorrichtung nach Anspruch 1, wobei die hochharte Verschleißschutzschicht (5) ohne Zwischenschicht, unmittelbar am Substrat (1) angeordnet ist.

3. Schneidvorrichtung nach wenigstens einem der vorangehenden Ansprüche, wobei die hochharte Verschleißschutzschicht (5) eine Dicke (d) in einem Bereich von 1 bis 20 Mikrometer aufweist.

4. Schneidvorrichtung nach wenigstens einem der vorangehenden Ansprüche, wobei das Substrat (1) - vorzugsweise stoffschlüssig und lotmittelfrei - mit einem Trägerkörper (6) verbunden ist.

5. Schneidvorrichtung nach wenigstens einem der Ansprüche 1 bis 3, wobei das Substrat (1) - vorzugsweise stoffschlüssig und lotmittelfrei - mit einer weiteren Lage (11) verbunden ist, wobei die weitere Lage (11) mit einem Trägerkörper (6) stoffschlüssig und lotmittelfrei, kraft-, reib-, und/oder formschlüssig verbunden ist.

6. Schneidvorrichtung nach Anspruch 1 bis 3, wobei das Substrat (1) kraft-, reib-, und/oder formschlüssig direkt mit einem Trägerkörper (6) verbunden ist.

7. Schneidvorrichtung nach dem vorangehenden Anspruch, wobei der Trägerkörper (6) als austauschbarer Schneideinsatz, vorzugsweise als Wendeschneidplatte, ausgebildet ist.

8. Schneidvorrichtung nach wenigstens einem der Ansprüche 4 bis 6, wobei der Trägerkörper (6) als Grundkörper eines rotierenden oder stehenden Werkzeugs mit einem Einspannabschnitt (7) für das Einspannen an einer Werkzeugmaschine ausgebildet ist.

9. Schneidvorrichtung nach wenigstens einem der Ansprüche 4 bis 8, wobei der Trägerkörper (6) über zumindest einen Kanal (8) zur Zuführung eines Mediums zum Kühlen und/oder Schmieren und/oder zum Abtransport von Spänen verfügt.

10. Schneidvorrichtung nach wenigstens einem der vorangehenden Ansprüche, wobei das Substrat (1) aus polykristallinem Diamant besteht und die hochharte Verschleißschutzschicht (5) aus Bornitrid besteht.

11. Schneidvorrichtung nach wenigstens einem der vorangehenden Ansprüche, wobei das Substrat (1) aus Bornitrid besteht und die hochharte Verschleißschutzschicht (5) aus Bornitrid oder aus polykristallinem Diamant besteht.

12. Schneidvorrichtung nach wenigstens einem der vorangehenden Ansprüche, wobei die eine der zwei Funktionsflächen (2, 3) als Spanfläche und die andere der zwei Funktionsflächen (2, 3) als Freifläche fungiert.

13. Schneidvorrichtung nach wenigstens einem der vorangehenden Ansprüche, wobei zwei Schneiden (4) und drei Funktionsflächen (2, 3) vorgesehen sind, von denen die eine Schneide (4) durch eine als Spanfläche fungierende erste Funktionsfläche (2) der drei Funktionsflächen (2, 3) und eine als Freifläche fungierende zweite Funktionsfläche (3) der drei Funktionsflächen (2, 3) definiert ist und die andere Schneide (4) durch die erste Funktionsfläche (2) und eine als Freifläche fungierende dritte Funktionsfläche (3) definiert ist und wobei die drei Funktionsflächen (2, 3) über die beiden Schneiden (4) hinweg zumindest teilweise, bevorzugt vollständig mit der hochharten Verschleißschutzschicht (5) bedeckt sind.

14. Verwendung einer Schneidvorrichtung nach wenigstens einem der vorangehenden Ansprüche für die Bearbeitung von Faserverbundwerkstoffen oder Leichtmetallen oder hochharten Werkstoffen, vorzugsweise Hartmetall oder Keramik, oder für die Bearbeitung von Verbundwerkstoffen aus den vorgenannten Materialien.
